# FASCICULE DE BREVET EUROPEEN

(11) **EP 0 803 729 B1**
(45) Date de publication et mention de la délivrance du brevet: **24.08.2005**
(21) Numéro de dépôt: 97106711.1
(22) Date de dépôt: 23.04.1997
(51) Int. Cl.: G01N 27/07, G01N 27/416

(54) **Dispositif comprenant deux substrats micro-usinés destinés à former un microsystème ou une partie d'un microsystème et procédé d'assemblage de deux substrats micro-usinés**
Vorrichtung mit zwei mikromechanischen Substraten für ein mikromechanisches System oder Teil eines mikromechanischen Systems und Verfahren zur Zusammensetzung zweier mikromechanischer Substrate
Device with two micromachined substrates for forming a microsystem or part of a microsystem and assembly method for two micromachined substrates

(30) Priorité: 26.04.1996 FR 9605319
(43) Date de publication de la demande: 29.10.1997
(73) Titulaire: Colibrys S.A., 2007 Neuchâtel (CH)
(72) Inventeur: Cardot, Francis, 2006 Neuchâtel (CH); Arquint,Philippe, 91074 Herzogenaurach (DE); Van der Schoot,Bart, 2006 Neuchâtel (CH)
(74) Mandataire: P&TS Patents & Technology Surveys SA

(56) Documents cités:
- EP-A- 0 528 251
- EP-A- 0 695 941
- US-A- 5 504 035

## Description

L'invention concerne généralement les dispositifs micro-usinés, et plus particulièrement, un dispositif comprenant au moins deux substrats destinés à former un microsystème ou une partie d'un microsystème tel qu'un capteur réalisé par exemple par l'assemblage d'au moins deux substrats micro-usinés. L'invention concerne également un procédé d'assemblage de deux substrats micro-usinés, notamment pour réaliser un dispositif tel que mentionné ci-dessus.

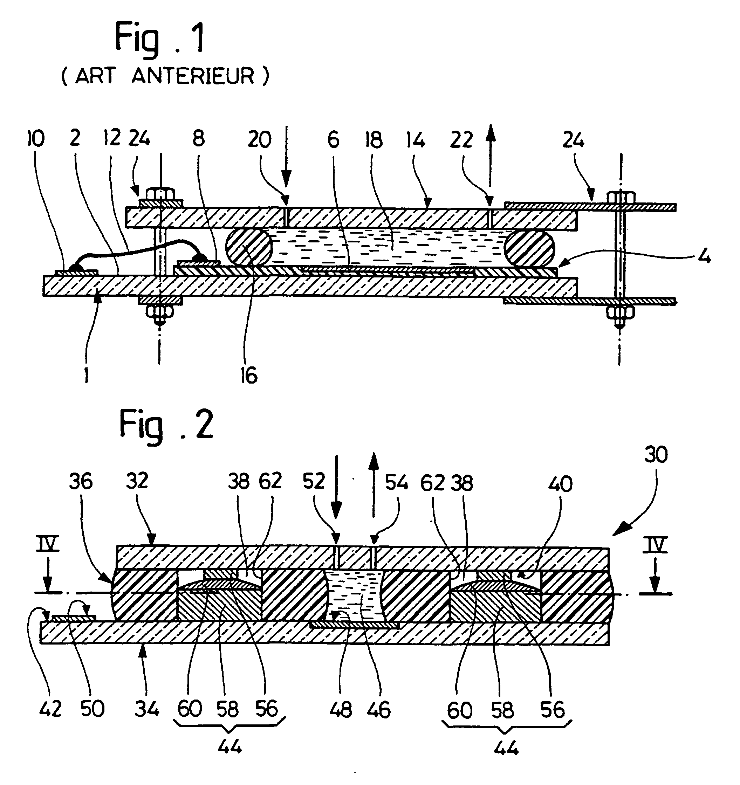

On connaît déjà des dispositifs comprenant plusieurs substrats, par exemple un collecteur d'écoulement muni d'un capteur chimique tel qu'un capteur de pH, représenté de façon schématique en coupe à la figure 1.

Un tel collecteur comprend un premier substrat 1 sur une face 2 duquel est fixé un module capteur 4 comprenant par exemple une plaque de silicium sur laquelle est intégrée une cellule de détection 6 comprenant notamment des électrodes de mesure (non représentées) reliées respectivement à des plages de contact 8 correspondantes. Celles-ci sont reliées à des plots de contact 10 solidaires du premier substrat 1 par soudage de fils 12, en vue d'une liaison avec un circuit de mesure extérieur (non représenté).

Le collecteur comprend en outre un deuxième substrat 14 superposé au premier substrat 1, un joint O-ring 16 étant interposé entre les deux substrats 1 et 14 de sorte que le contour du joint 16 entoure la zone de la plaque 4 comprenant la cellule de détection 6. La plaque 4, le joint torique (O-ring) 16 et le substrat 14 délimitent ainsi une chambre collectrice 18 étanche dans laquelle peut circuler un fluide via un canal d'entrée 20 et un canal de sortie 22 ménagés dans le substrat 14 de manière appropriée. L'étanchéité de la chambre 18 vis-à-vis des autres éléments du dispositif est réalisée en maintenant les deux substrats 1 et 14 serrés l'un contre l'autre au moyen d'un système de brides de serrage 24 à vis ou analogues.

L'utilisation d'un tel système de serrage présente l'inconvénient d'être lourd et coûteux et d'être d'une mise en oeuvre délicate.

Par ailleurs, l'utilisation d'un joint O-ring présente l'inconvénient de rendre difficile la réalisation d'une étanchéité parfaite dans les cas où les surfaces du dispositif en contact avec le joint ne sont pas lisses mais plus ou moins fortement structurées, ce qui est le cas de nombreuses cellules de détection.

En effet, l'application d'un joint de ce type sur des surfaces structurées conduit à des risques de fuites importantes du liquide à tester dans le dispositif, ce qui peut endommager des éléments environnants et ce, notamment, dans le cas où le liquide à tester contient des agents chimiques agressifs, ou inversement conduire à des risques de pollution du liquide circulant dans la chambre collectrice.

Une alternative à l'utilisation de systèmes de serrage tels que celui décrit plus haut et de joints O-ring est par exemple donnée par la demande de brevet EP-A-0 528 251 (Honda Giken Kogyo Kabushiki Kaisha) qui décrit un senseur pour la détection d'une déflection ou d'une variation d'intensité d'un flux gazeux à travers une chambre, comprenant deux substrats semiconducteurs. La chambre de ce senseur est formée par la gravure d'au moins un des deux substrats et l'assemblage approprié de ces derniers. Les surfaces par lesquelles les deux substrats sont joints sont recouvertes de films de matériaux dissemblables pouvant être alliés entre eux sous l'effet de la chaleur. Les deux substrats sont pressés l'un contre l'autre et chauffés jusqu'à être soudés l'un à l'autre. L'étanchéité de la chambre est ainsi assurée par la soudure entre les deux substrats. Un désavantage majeur de ce mode de réalisation est cependant que le fluide traversant la chambre est en contact direct avec la soudure et n'est donc pas protégé d'une éventuelle pollution par les matériaux utilisés pour cette soudure. Or une telle pollution risque par exemple de fausser les résultats de certaines mesures pouvant être effectuées sur le fluide traversant la chambre, en particulier dans le cas de mesures de caractéristiques chimiques du fluide telles que par exemple son pH.

Ainsi, l'invention a pour but principal de remédier aux inconvénients de l'art antérieur susmentionné en fournissant un dispositif comportant au moins deux substrats, destiné à former un microsystème ou une partie d'un microsystème, qui soit aisé et économique à mettre en oeuvre et qui permette, dans le cas d'un dispositif destiné à véhiculer un fluide, de protéger efficacement les éléments du dispositif du fluide transporté et également de protéger le fluide contre toute pollution par les éléments du dispositif en garantissant l'étanchéité désirée.

Ces buts sont en partie atteints par un dispositif comprenant de préférence un premier substrat et un deuxième substrat entre lesquels est intercalée une couche de polymère comprenant au moins une cavité qui s'étend du premier au deuxième substrat. Des moyens de liaison par soudure sont prévus dans la cavité pour assurer une liaison mécanique résistante à la traction entre les deux substrats.

Un procédé de soudure apparenté est par exemple décrit dans le brevet US-A-5 504 035 (LSI Logic Corporation) pour la soudure d'un composant semiconducteur sur un substrat. Une structure planaire préformée, par exemple en une résine organique telle que du polyimide, est ainsi placée entre le composant semiconducteur et le substrat dans le but d'améliorer la qualité de la soudure. La structure planaire préformée comprend des trous dont la disposition correspond aux points de soudure entre les éléments à assembler. De la matière à souder est déposée en ces points sur les faces correspondantes du composant semiconducteur et du substrat. Le composant semiconducteur, la structure planaire préformée et le substrat sont alors assemblés et pressés, puis chauffés jusqu'a ce que la matière à souder forme une soudure entre le composant semiconducteur et le substrat, à travers le trou correspondant de la structure planaire préformée. L'unique fonction de la structure planaire préformée décrite dans ce document est cependant limitée à l'amélioration de la qualité du processus de soudure.

Les buts de l'invention sont ainsi atteints en particulier par un dispositif comportant un premier substrat et un deuxième substrat destinés à former un microsystème tel qu'un capteur, au moins l'un des substrats pouvant comporter des éléments de circuit électronique, dans lequel une couche de polymère est intercalée entre le premier et le deuxième substrat, la couche de polymère comprenant au moins une cavité qui s'étend du premier au deuxième substrat, et dans lequel des moyens de liaison par soudure sont prévus dans la cavité, les moyens de soudure assurant une liaison mécanique résistante à la traction entre les deux substrats, le dispositif comprenant une chambre destinée à recevoir un fluide, par exemple un liquide ou un gaz, ménagée dans la couche de polymère, le polymère de la couche assurant l'étanchéité entre la chambre et la cavité et/ou l'extérieur.

On peut ainsi éliminer les systèmes de serrage à vis pour l'assemblage des substrats, et obtenir un assemblage mécanique par soudure fiable. Les joints O-ring utilisés dans l'art antérieur sont remplacés par la couche de polymère qui peut être, par exemple, aisément déposée sur l'un des substrats avant leur assemblage, cette couche épousant alors tous les reliefs que présente le substrat et éliminant ainsi les problèmes d'étanchéité évoqués ci-dessus. On notera à ce propos que l'on choisira, de préférence, un polymère compressible pour des raisons qui apparaîtront plus clairement dans la suite de la description.

Selon une caractéristique avantageuse de l'invention, le moyens de liaison par soudure comprennent des plages à souder ménagées respectivement sur chaque substrat et de la matière à soudure reliant la plage à souder du premier substrat à la plage à souder du deuxième substrat.

Cet assemblage mécanique peut ainsi également assurer de façon avantageuse une liaison électrique et thermique entre les substrats, respectivement pour, le cas échéant, renvoyer un contact électrique d'un substrat sur l'autre et pour contribuer à une dissipation plus efficace de la chaleur produite lors du fonctionnement du dispositif.

Selon une autre caractéristique de l'invention, la couche de polymère est comprimée entre le premier et le deuxième substrat, et la soudure est soumise à un effort de traction permanent, le polymère étant comprimé entre les deux substrats.

La compression de la couche de polymère entre les deux substrats permet ainsi de garantir une grande étanchéité des cavités dans lesquelles s'étendent les moyens de liaison par soudure vis-à-vis de l'extérieur.

Dans le cadre de l'invention, on peut ainsi profiter avantageusement de la couche de polymère pour y former également des moyens fonctionnels du dispositif, notamment des cavités étanches ou chambres collectrices de formes quelconques dans lesquelles peuvent circuler un fluide à tester, les moyens de liaison par soudure étant là encore protégés et isolés des cavités dans lesquelles circule un fluide, par exemple un liquide ou un gaz, par la couche de polymère, si bien que les fluides à tester sont aussi protégés le cas échéant contre toute pollution par les métaux utilisés par la soudure.

Selon une caractéristique préférée de l'invention, le polymère de la couche est un polymère faisant partie la famille des polysiloxanes.

Ces polymères présentent l'avantage de pouvoir subir une double polymérisation et ainsi de pouvoir au cours de la deuxième polymérisation adhérer aux substrats, augmentant ainsi l'étanchéité et la cohésion du dispositif.

Selon encore un autre aspect, l'invention a pour objet un procédé d'assemblage de deux substrats, caractérisé en ce qu'il consiste à:
- se munir d'un premier substrat comportant sur une de ses faces au moins une première plage à souder
- se munir d'un deuxième substrat,
- déposer sur une face du deuxième substrat une couche de polymère photosensible,
- structurer la couche de polymère photosensible pour former au moins une cavité débouchant sur ladite face et une chambre destinée à recevoir un fluide, par exemple un liquide ou un gaz,
- former dans ladite cavité une deuxième plage à souder destinée à être soudée à ladite première plage,
- apporter de la matière de soudure sur au moins une desdites première et deuxième plages à souder,
- placer la face du premier substrat comportant la plage à souder sur la couche de polymère pour que la première plage à souder soit en regard de la cavité.
- assembler les premier et deuxième substrats par soudage des premières et deuxièmes plages à souder.

On notera que selon ce procédé, on tire parti de façon avantageuse de la structuration de la couche de polymère pour utiliser la ou les cavités comme moule pour la formation des plages à souder, par exemple pour la croissance galvanique d'un métal destiné à former la plage à souder.

Par ailleurs, l'utilisation de cette couche de polymère permet de réaliser des joints d'étanchéité ayant des formes et des largeurs quelconques en fonction de l'application souhaitée.

D'autres caractéristiques et avantages de l'invention apparaîtront plus clairement à la lecture de la description suivante d'un mode de réalisation de l'invention donné à titre purement illustratif et non limitatif, cette description étant faite en liaison avec le dessin dans lequel:
- la figure 1 est une vue en coupe d'un dispositif de l'art antérieur;
- la figure 2 est une vue en coupe d'un microsystème comprenant deux substrats assemblés selon l'invention;
- les figures 3 et 4 sont des vues en élévation respectivement des substrats supérieur et inférieur du microsystème de la figure 2 avant assemblage; et
- les figures 5 à 7 sont des vues en coupe du dispositif de la figure 2 représenté à différentes étapes du procédé d'assemblage de deux substrats selon l'invention.

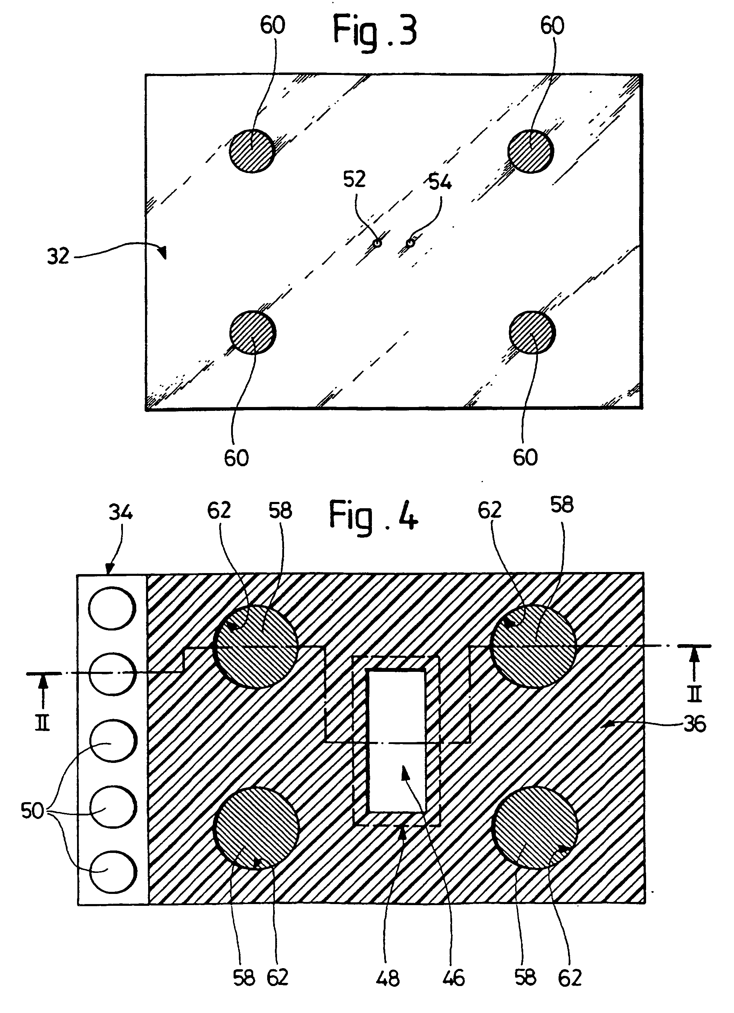

En se référant aux figures 2 à 4, on voit une coupe d'un exemple de réalisation d'un dispositif destiné à former un microsystème, en l'occurrence une partie d'un capteur chimique tel qu'un capteur de ph, désigné par la référence numérique générale 30.

On notera à titre préliminaire que le dessin ne représente pas les dimensions relatives exactes des éléments les uns par rapport aux autres et que les dimensions ont été fortement exagérées pour plus de clarté. A titre indicatif, les dimensions générales d'un tel dispositif sont de l'ordre de 10 x 10 x 1 mm³.

Le dispositif 30 comprend un premier substrat 32 et un deuxième substrat 34 entre lesquels est intercalée une couche d'un polymère compressible 36. A titre d'exemple, les substrats peuvent être réalisés en un matériau semi-conducteur tel que le silicium.

La couche de polymère 36 est de préférence réalisée à partir d'un polymère ayant des propriétés photosensibles pour des raisons qui apparaîtront ultérieurement et de préférence qui fait partie de la famille des polysiloxanes.

La couche de polymère 36 comprend quatre cavités 38 s'étendant entre les faces respectivement opposées 40 et 42 des substrats 32 et 34, cavités dans lesquelles sont prévus des moyens de soudure 44 assurant la liaison mécanique entre les substrats 32 et 34.

La couche de polymère 36 comprend dans l'application illustrée aux figures une chambre collectrice 46 destinée à recevoir un échantillon liquide ou gazeux à tester et dans laquelle est prévue une cellule de détection 48 du pH dans l'exemple illustré. La cellule de détection 48 présente par exemple une pluralité d'électrodes intégrées sur le substrat 34 et reliées à des plages de contact 50 situées à l'extérieur de la chambre 46.

Cette chambre collectrice 46 est alimentée via un canal d'entrée 52 prévu dans le substrat 32. Le liquide ou le gaz, après être venu en contact avec la cellule de détection 48, est évacué de la chambre 46 par un canal de sortie 54.

Les moyens de soudure 44 comprennent des plages à souder 56, 58, ménagées respectivement sur les faces 40, 42 des substrats 32 et 34 dans les cavités 38, et de la matière à souder 60 qui relie les plages à souder 56 du substrat 32 aux plages à souder 58 du substrat 34. Les plages à souder sont réalisées en métal et de préférence ces plages à souder sont réalisées en nickel. Bien entendu, tout autre métal apte à former une liaison mécanique entre le substrat et la soudure peut être utilisé.

Les plages à souder 56, 58 des substrats 32 et 34 sont reliées au moyen de la matière à soudure 60, de préférence un alliage de soudure au plomb et à l'étain.

Pour garantir une bonne étanchéité de la chambre collectrice 46 vis-à-vis de l'extérieur du dispositif et des cavités 38 vis-à-vis de l'extérieur du dispositif d'autre part, la couche de polymère 36 est comprimée entre les substrats 32 et 34 si bien que la liaison par soudure 44 est soumise à un effort de traction exercé par le polymère comprimé.

La couche de polymère 36 est de préférence solidaire d'au moins un des substrats 32, 34. A ce propos, on choisira de réaliser la couche de polymère sur le substrat dont la surface en contact avec celle-ci comporte la plus grande structuration ou les reliefs les plus importants. Toutefois, comme on le verra ci-après en liaison avec la description du procédé d'assemblage, au moment de la soudure, l'ensemble des deux substrats avec la couche de polymère est comprimé et subit une élévation de température pour atteindre la température du fusion de la matière de soudure, ce qui permet de réaliser simultanément une seconde polymérisation du polymère au cours de laquelle est crée une liaison de la couche de polymère avec les substrats.

Bien entendu, la couche de polymère 36 peut, selon une variante de réalisation, être réalisée sous la forme d'une feuille solidaire d'aucun des substrats et être préparée séparément avec une structuration appropriée des cavités. Dans ce cas, la feuille structurée est simplement maintenue comprimée entre les substrats par la liaison par soudure.

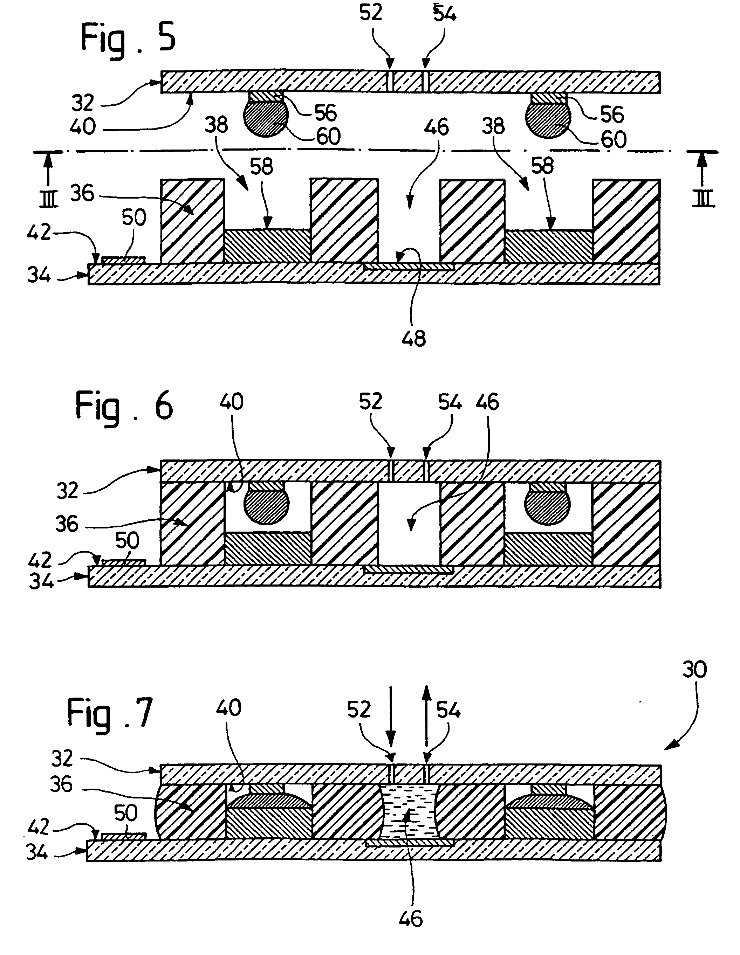

En se référant désormais aux figures 5 à 7, on va décrire le procédé d'assemblage de deux substrats, notamment pour la réalisation du dispositif ou microsystème 30 qui vient d'être décrit. Dans les figures 5 à 7, les éléments identiques à ceux décrits en liaison avec les figures 2 à 4 portent les mêmes référence numériques.

Bien que le procédé de l'invention permette l'assemblage de deux substrats pour la réalisation simultanée d'une pluralité de microsystèmes fonctionnels, la description et les figures ne porteront, par simplification, que sur un seul dispositif fonctionnel. En effet, le procédé est, de préférence, un procédé en "batch" (par lots) qui permet de fabriquer simultanément une pluralité de dispositifs sur une même plaquette.

Les plaquettes formant les premier et deuxième substrats 32 et 34 à partir desquels est fabriqué le dispositif ou microsystème 30 sont réalisées de préférence en un matériau semi-conducteur tel que le silicium.

A la figure 5 on a représenté le premier substrat 32 après la formation sur la face 40 des plages à souder 56 et le dépôt sur ces plages à souder de la matière à souder 60, ainsi que le deuxième substrat 34 après la formation de la couche 36 et des plages à souder 58.

La formation des plages à souder 56 est réalisée de façon classique par évaporation sous vide d'un métal, par exemple du nickel ou de l'aluminium, à travers un masque (non représenté). Bien entendu ces plages à souder 56 et 58 peuvent être également réalisées par tout autre moyen, par exemple par pulvérisation cathodique. La matière à souder 60 est également déposée de la même façon sur les plages 56 à travers un masque.

Pour réaliser le substrat 34 tel qu'il est représenté à la figure 5, on a déposé sur sa face 42 une couche de polymère photosensible 36, par exemple par centrifugation à la tournette. La surface supérieure ainsi obtenue est plane et lisse ce qui améliore l'étanchéité lors de son application contre l'autre substrat. En outre, la couche de polymère épouse les reliefs que pourrait comporter la face du substrat sur laquelle elle est déposée. Ensuite, la couche de polymère 36 a été insolée à travers un masque (non représenté) ayant une configuration appropriée. Les parties insolées de la couche de polymère 36 ont été ensuite éliminées classiquement, par exemple par voie humide, pour former les cavités 38 et la chambre collectrice 46 jusqu'à faire apparaître la surface 42 du substrat 34.

Le polymère formant la couche 36 sera de préférence un polysiloxane, ce polymère photosensible ayant de bonnes propriétés de planarisation et étant apte à subir une double polymérisation lui conférant ainsi des propriétés supplémentaires d'adhésion. Par ailleurs ce polymère présente une bonne aptitude à la compression.

L'étape suivante consiste à former les plages à souder 58 dans le fond des cavités 38 qui viennent d'être formées dans la couche 34. Pour ce faire, on utilise, de préférence, les cavités 38 comme moules pour faire croître galvaniquement un métal destiné à former les plages à souder 58. Le métal utilisé pour former ces plages à souder 58 est de préférence le nickel.

Il est clair pour l'homme de métier que l'opération de croissance galvanique nécessite, au préalable, la réalisation d'électrodes au fond des cavités 38. Cette réalisation d'électrodes pourra être faite par tout moyen connu approprié.

Au cours de l'étape suivante, représentée à la figure 6, les substrats 32 et 34 sont placés l'un sur l'autre de manière que les plages à souder 56 munies de la matière à souder 60 pénètrent respectivement dans les cavités correspondantes 28 ménagées dans la couche de polymère 34 et viennent ainsi en regard des plages à souder correspondantes 58.

Les deux substrats 32 et 34 étant ainsi préparés, ils sont mis en place dans un aligneur-soudeur (non-représenté) dans lequel on leur applique une pression suffisante pour comprimer la couche 34 tout en étant chauffés à une température suffisante pour faire fondre la matière de soudure 60 et réaliser la liaison par soudure des plages à souder 56 et 58. Typiquement, dans le cas de l'utilisation d'un alliage plomb/étain comme matière de soudure, on chauffera l'ensemble des deux substrats de sorte que la matière de soudure atteigne une température d'environ 200°C.

On notera qu'au cours de l'opération de croissance galvanique, on veillera bien entendu à ce que l'épaisseur des plages à souder 58 soit suffisante pour que lorsque les substrats 32 et 34 sont superposés et que la couche de polymère est comprimée, la matière de soudure vienne en contact avec la plage à souder qu'elle doit relier.

Selon l'application, les plages à souder reliées à des composants électroniques intégrés du substrat et les moyens de soudure assurent également le renvoi d'un contact électrique d'un substrat à l'autre.

Le dispositif qui vient d'être décrit trouve des applications notamment dans les domaines de la fluidique, des capteurs chimiques ou biologiques, des têtes d'imprimantes à jet d'encre et analogues.

## Revendications

1. Dispositif (30) comportant un premier substrat (32) et un deuxième substrat (34) destinés à former un microsystème tel qu'un capteur, au moins l'un des substrats (32, 34) pouvant comporter des éléments de circuit électronique, dans lequel une couche de polymère (36) est intercalée entre le premier et le deuxième substrat, la couche de polymère (36) comprenant au moins une cavité (38) qui s'étend du premier au deuxième substrat, et dans lequel des moyens de liaison par soudure (44) sont prévus dans la cavité (38), lesdits moyens de soudure (44) assurant une liaison mécanique résistante à la traction entre les deux substrats (32, 34), ledit dispositif (30) étant **caractérisé en ce qu'**il comprend une chambre (46) destinée à recevoir un fluide, par exemple un liquide ou un gaz, ménagée dans la couche de polymère (36), le polymère de la couche assurant l'étanchéité entre la chambre (46) et la cavité (38) et/ou l'extérieur.

2. Dispositif selon la revendication 1, **caractérisé en ce qu'**il comprend au moins un canal d'entrée et/ou de sortie (52, 54) prévu dans au moins un desdits premier et deuxième substrats (32, 34) pour alimenter ladite chambre (46) en ledit fluide et/ou pour évacuer ledit fluide de ladite chambre (46).

3. Dispositif selon l'une des revendications 1 ou 2, **caractérisé en ce que** le polymère fait partie de la famille des polysiloxanes.

4. Procédé d'assemblage de deux substrats (32, 34), notamment pour réaliser un dispositif (30) selon l'une des revendications 1 à 3, consistant à :
- se munir d'un premier substrat (32) comportant sur une de ses faces une première plage à souder (56)
- se munir d'un deuxième substrat (34),
- déposer sur une face (42) du deuxième substrat (34) une couche de polymère photosensible (36),
- structurer la couche de polymère photosensible (36) pour former au moins une cavité (38) débouchant sur ladite face (42) du deuxième substrat (34) et pour former une chambre (46) destinée à recevoir un fluide, par exemple un liquide ou un gaz,
- former dans ladite cavité (38) une deuxième plage à souder (58) destinée à être soudée à ladite première plage (56),
- apporter de la matière de soudure (60) sur au moins une desdites première et deuxième plages à souder (56, 58),
- placer la face (40) du premier substrat (32) comportant la plage à souder (56) sur la couche de polymère (36) pour que la première plage à souder (56) soit en regard de la cavité (38).
- assembler les premier et deuxième substrats (32, 34) par soudage des première et deuxième plages à souder (56, 58).

5. Procédé selon la revendication 4, **caractérisé en que** l'étape de formation de la deuxième plage à souder (58) comprend la croissance galvanique d'un métal dans la cavité (38).

6. Procédé selon la revendication 4 ou 5, **caractérisé en que** la couche de polymère photosensible (36) est comprimée préalablement à l'étape de soudage et est maintenue comprimée au cours de cette étape.

## Patentansprüche

1. Vorrichtung (30) mit einem ersten Substrat (32) und einem zweiten Substrat (34) dazu bestimmt, ein Mikrosystem wie einen Sensor zu bilden, wobei mindestens eines der Substrate (32, 34) Elemente eines elektronischen Schaltkreises umfassen kann, worin eine Polymerschicht (36) zwischen dem ersten und dem zweiten Substrat eingelagert werden kann, wobei die Polymerschicht (36) mindestens eine sich vom ersten zum zweiten Substrat erstreckende Aushöhlung (38) umfasst, und worin Lötverbindungsmittel (44) in der Aushöhlung (38) vorgesehen sind, wobei besagte Lötmittel (44) eine mechanische, reissfeste Verbindung zwischen den beiden Substraten (32, 34) gewährleisten, wobei besagte Vorrichtung (30) **dadurch gekennzeichnet ist, dass** sie eine Kammer (46) umfasst, die dazu bestimmt ist, ein Fluid, beispielsweise eine Flüssigkeit oder ein Gas, zu empfangen, und in der Polymerschicht (36) vorgesehen ist, wobei das Polymer der Schicht die Dichtheit zwischen der Kammer (46) und der Aushöhlung (38) und/oder der Aussenwelt gewährleistet.

2. Vorrichtung gemäss Anspruch 1, **dadurch gekennzeichnet, dass** sie mindestens einen in mindestens einem der besagten ersten und zweiten Substrate (32, 34) vorgesehenen Eingangs- und/oder Ausgangskanal (52, 54) umfasst, um besagte Kammer (46) mit besagtem Fluid zu füllen und/oder besagtes Fluid zu evakuieren.

3. Vorrichtung gemäss einem der Ansprüche 1 oder 2, **dadurch gekennzeichnet, dass** das Polymer der Polysiloxanfamilie angehört.

4. Verfahren zum Verbinden von zwei Substraten (32, 34), insbesondere zur Herstellung einer Vorrichtung (30) gemäss einem der Ansprüche 1 bis 3, bestehend aus:
sich mit einem ersten Substrat (32) versehen, mit einem Lötbereich (56) auf einer seiner Seiten,
sich mit einem zweiten Substrat (34) versehen,
eine lichtempfindliche Polymerschicht (36) auf einer Seite (42) des zweiten Substrats (34) ablagern,
die lichtempfindliche Polymerschicht (36) strukturieren, um mindestens eine Aushöhlung (38) zu bilden, die auf besagter Seite (42) des zweiten Substrats (34) mündet, und um eine Kammer (46) zu bilden, die dazu bestimmt ist, ein Fluid, beispielsweise eine Flüssigkeit oder ein Gas, zu empfangen,
in besagter Aushöhlung (38) einen zweiten Lötbereich (58) bilden, der dazu bestimmt ist, mit besagtem ersten Lötbereich (56) verlötet zu werden,
Lötmaterial (60) auf mindestens einen der besagten ersten und zweiten Lötbereichen (56, 58) zuführen,
die Seite (40) des ersten Substrats (32) mit dem Lötbereich (56) auf die Polymerschicht (36) legen, damit der erste Lötbereich (56) sich gegenüber der Aushöhlung (38) befindet,
das erste und zweite Substrat (32, 34) durch Löten der ersten und zweiten Lötbereiche (56, 58) verbinden.

5. Verfahren gemäss Anspruch 4, **dadurch gekennzeichnet, dass** der Schritt vom Bilden des zweiten Lötbereichs (58) die Elektroplattierung eines Metalls in der Aushöhlung (38) umfasst.

6. Verfahren gemäss dem Anspruch 4 oder 5, **dadurch gekennzeichnet, dass** die lichtempfindliche Polymerschicht (36) vor dem Lötschritt komprimiert wird und während diesem Schritt komprimiert gehalten wird.

## Claims

1. Device (30) comprising a first substrate (32) and a second substrate (34) designed to form a microsystem such as a sensor, at least one of the substrates (32, 34) being capable of including electronic circuit elements, wherein a layer of polymer (36) is interposed between the first and the second substrate, the polymer layer (36) comprising at least one cavity (38) which extends from the first to the second substrate, and wherein solder attaching means (44) are provided in the cavity (38), said solder means (44) assuring a traction resistant mechanical connection between the two substrates (32, 34), and wherein said device (30) is **characterised in that** it comprises a chamber (46) designed to receive a fluid, for example a liquid or a gas, arranged in the polymer layer (36), the polymer of the layer assuring the sealing between the chamber (46) and the cavity (38) and/or the exterior.

2. Device according to claim 1, **characterised in that** it comprises at least one entry and/or exit channel (52, 54) provided in at least one of said first and second substrate (32, 34) to feed said chamber (46) with said fluid and/or for evacuating said fluid from said chamber (46).

3. Device according to one of the claims 1 or 2, **characterised in that** the polymer belongs to the polysiloxane family.

4. Method for assembling two substrates (32, 34), notably for making a device (30) according to one of the claims 1 to 3, consisting of:
providing a first substrate (32) comprising on one of its surfaces a first bonding pad (56),
providing a second substrate (34),
depositing on one surface (42) of the second substrate (34) a layer of photosensitive polymer (36),
structuring the layer of photosensitive polymer (36) to form at least one cavity (38) opening onto said surface (42) of the second substrate (34) and to form a chamber (46) designed to receive a fluid, for example a liquid or a gas,
forming in said cavity (38) a second bonding pad (58) designed to being soldered to said first pad (56),
supplying soldering material (60) onto at least one of said first and second bonding pad (56, 58),
placing the surface (40) of the first substrate (32) comprising the bonding pad (56) onto the polymer layer (36) so that the first bonding pad (56) is opposite the cavity (38),
assembling the first and second substrates (32, 34) by welding the first and second bonding pads (56, 58).

5. Method according to claim 4, **characterised in that** the step of forming the second bonding pad (58) comprises the galvanic growth of a metal in the cavity (38).

6. Method according to the claim 4 or 5, **characterised in that** the layer of photosensitive polymer (36) is compressed prior to the soldering step and is held compressed during this step.
